# EUROPEAN PATENT SPECIFICATION

(11) **EP 3 477 782 B1**
(45) Date of publication and mention of the grant of the patent: **10.03.2021**
(21) Application number: 18201727.7
(22) Date of filing: 22.10.2018
(51) Int. Cl.: H01R 12/71, H01R 13/52, H01R 13/621, H01R 13/10, H01R 13/74, H01R 107/00, H01R 24/76

(54) **DIRECT COUPLING CONNECTOR ASSEMBLY**
DIREKTKUPPLUNGSVERBINDERANORDNUNG
ENSEMBLE DE CONNECTEUR DE COUPLAGE DIRECT

(30) Priority: 25.10.2017 KR 20170139039; 07.09.2018 KR 20180107242
(43) Date of publication of application: 01.05.2019
(73) Proprietor: Tyco Electronics AMP Korea Co., Ltd., Gyeongsan-si, Gyeongsangbuk-do 38459 (KR)
(72) Inventor: Lim, Kun Taek, 38459 Gyeongsangbuk-do (KR); Lee, Sang Moon, 38459 Gyeongsangbuk-do (KR)
(74) Representative: Johnstone, Douglas Ian

(56) References cited:
- US-A- 3 159 444
- US-A- 4 684 190
- US-A- 5 266 047
- US-A- 5 743 756
- US-A1- 2011 053 404
- US-A1- 2011 182 694

## Description

The present application relates to a direct coupling connector assembly.

A connector refers to a type of an electrical part that may selectively perform an electrical connection, that is, selectively connect or disconnect electricity. The connector may connect different two modules. For example, the connector may be mounted to a suspension and a wheel of a vehicle and may electrically connect the suspension and the wheel. The connector may require a sealing structure to prevent an external material from penetrating between two modules or to prevent fluid provided in a module from leaking to the outside. For example, a vehicular connector needs to be in a sealing structure for preventing oil provided in a suspension from leaking to the outside and also needs to be in a sealing structure for preventing fluid from flowing in through wheels during driving.

A prior art connector assembly is disclosed in patent US 3159444. The connector includes a first connector with a body including a radially extending mounting flange from which a cylindrical metal shell projects, inside which an annular seal is position. A rear end of the body includes radially extending webs which support a central internally screw-threaded hub. Several annular discs are positioned forwardly of the webs and sealingly support plural contacts. Wires extend from the contacts through spaces between the webs and out of the first connector. The connector assembly also includes a second connector which includes a forward shell section and a rearward shell section. The forward shell section is configured to fit inside the cylindrical metal shell of the first connector and engage the circular seal positioned therein. The forward shell section supports two discs, one of which comprises soft silicone rubber and in which plural contacts are mounted. The discs support a central longitudinally slotted tube with resilient fingers distal ends of which include screw-threaded portions which can be forced outwardly into engagement with the internal screw-thread of the hub of the first connector to permit screw threaded coupling between the first and second connectors. The second connector also includes a control rod with an end which is spring-biased into engagement with internal surfaces of the resilient fingers to urge them outwardly. Retraction of the control rod draws its end away from the ends of the resilient fingers allowing them to resile inwardly thereby disengaging the screw-threaded portions thereof out of engagement from the internal screw-thread of the hub of the first connector, thereby allowing separation of the first connector from the second connector. A further prior art connector is disclosed in patent US 2011/0053404 A1 which includes a forwardly projecting annular body portion on an outer surface of which an annular seal is provided in an annular groove of the annular body. A still further prior art connector is disclosed in patent US 4684190 which includes an annular mounting flange in a recess in which an annular seal is positioned.

At least one example embodiment provides a direct coupling connector assembly that may implement direct coupling without using a separate medium and may effectively seal between two modules.

According to the invention there is provided a direct coupling connector assembly comprising a male connector mountable to a first module provided with a first printed circuit board (PCB) and a female connector mountable to a second module provided with a second PCB, the direct coupling connector assembly wherein: the male connector comprises a male connector body comprising a male flange and a male protrusion configured to protrude from the male flange, a plurality of male contacts which penetrate the male connector body and are connectable to the first PCB, a coupling bolt configured to connect to the male connector so as to be rotatable in place, and a male O-ring recessed into the male flange; and the female connector comprises a female connector body comprising a female flange and a female protrusion configured to protrude from the female flange, a plurality of female contacts each comprising a pin which penetrate through the female connector body and are connectable to the second PCB and a receptor connected to an end of the pin, an inner seal provided in the female protrusion and configured to be in contact with at least a portion of the male connector, a coupling nut provided in the female connector body, a female O-ring recessed into an outer wall of the female protrusion, and a support protruding from a center of the female flange and supporting the coupling nut, wherein the female protrusion comprises: an inner female protrusion separate from the support and surrounding an outer side of the support, and configured to protrude from the female flange; and an outer female protrusion separate from the inner female protrusion and configured to surround the inner female protrusion, the male protrusion comprising: an inner male protrusion separate from the coupling bolt and configured to protrude from the male flange and to be inserted into an inner side of the inner female protrusion; an outer male protrusion configured to be insertable between the inner female protrusion and the outer female protrusion; and a coupling O-ring surrounding the coupling bolt, the coupling bolt comprising a coupling groove indented in a direction perpendicular to a lengthwise direction of the coupling bolt and configured to support the coupling O-ring.

The inner seal may include a first seal part configured to be in contact with the male protrusion; and a second seal part configured to vertically extend from the first seal part and to be in contact with an inner wall of the male protrusion.

The female connector may include a family seal configured to insert into the female connector body and to support the plurality of female taps with elasticity; and a seal holder configured to insert into the female connector body, to support the family seal, and to support the plurality of female taps.

The female connector may further include a female potting portion provided in a space between the female protrusion and the family seal.

The female connector body may include a plurality of body holes provided to face the seal holder based on the family seal and configured to penetrate the female connector body in a direction perpendicular to the family seal.

The male connector may further include a deviation preventer configured to prevent the coupling bolt from being deviated in a first direction relative to the male connector body.

The coupling bolt may include a pressing portion formed on an outer wall of the coupling bolt and configured to press the mail connector body and to prevent the coupling bolt from being deviated in a second direction that is opposite to the first direction.

One of the male connector and the female connector may include a plurality of ribs configured to insert into the other connector.

Among at least a portion of the plurality of ribs, an interval between neighboring ribs may differ from an interval between another neighboring ribs.

According to example embodiments, a direct coupling connector assembly may electrically connect two modules in such a manner that a male connector mounted to one module may directly couple with a female connector mounted to another module without using a separate medium.

Also, according to example embodiments, a direct coupling connector assembly may connect a male tap and a female tap in a state in which the male tap and the female tap are accurately aligned, through a rib that protrudes from a connector body and a coupling bolt that makes an initial contact with the female connector compared to the male tap, and the like.

Also, according to example embodiments, a direct coupling connector assembly may provide a space for receiving a plurality of seals and may seal an interval between module and a connector and an interval between connectors.

Also, according to example embodiments, a direct coupling connector assembly may enhance durability of a connector by reducing a magnitude of vibration transferred between a male connector and a female connector using an inner seal.

Also, according to example embodiments, a user may observe whether a potting material is appropriately injected through body holes formed in a female connector of a direct coupling connector assembly.

Additional aspects of example embodiments will be set forth in part in the description which follows and, in part, will be apparent from the description, or may be learned by practice of the disclosure.

These and/or other aspects, features, and advantages of the invention will become apparent and more readily appreciated from the following description of example embodiments, taken in conjunction with the accompanying drawings of which:
FIG. 1 is a perspective view of a direct coupling connector assembly according to an example embodiment;
FIG. 2 is an exploded perspective view of a direct coupling connector assembly according to an example embodiment;
FIG. 3 is a cross-sectional view of a direct coupling connector assembly according to an example embodiment;
FIG. 4 is a cross-sectional view illustrating a sealing structure of a direct coupling connector assembly according to an example embodiment;
FIG. 5 is an exploded perspective view of a female tap according to an example embodiment;
FIG. 6 is a bottom view of a female connector according to an example embodiment;
FIG. 7 is a cross-sectional view of a female connector and illustrating a state in which a family seal and a seal holder are separate according to an example embodiment;
FIG. 8 is a cross-sectional view of a female connector according to an example embodiment;
FIG. 9 is a cross-sectional view of a direct coupling connector assembly according to an example embodiment;
FIG. 10 is a cross-sectional view of a direct coupling connector assembly according to an example embodiment;
FIG. 11 is a cross-sectional view of a direct coupling connector assembly according to an example embodiment;
FIG. 12 is a cross-sectional view of a direct coupling connector assembly according to an example embodiment; and
FIG. 13 is a partially enlarged cross-sectional view of a direct coupling connector assembly according to an example embodiment.

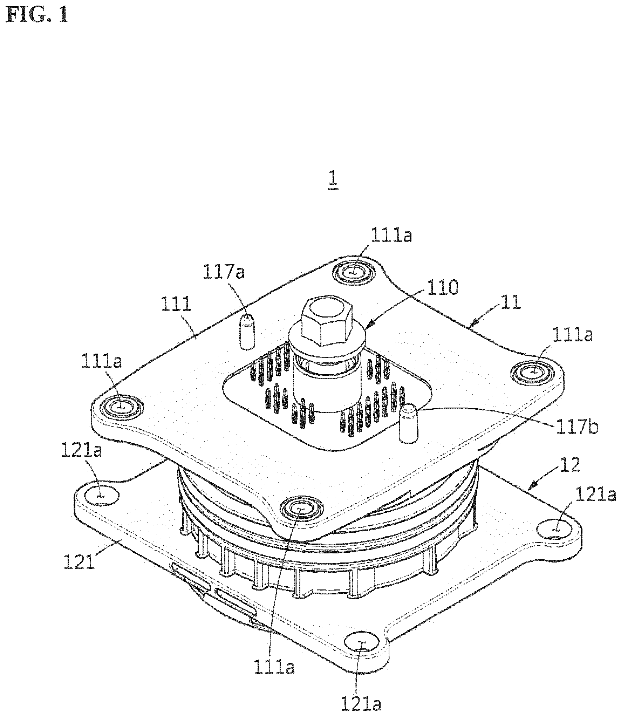

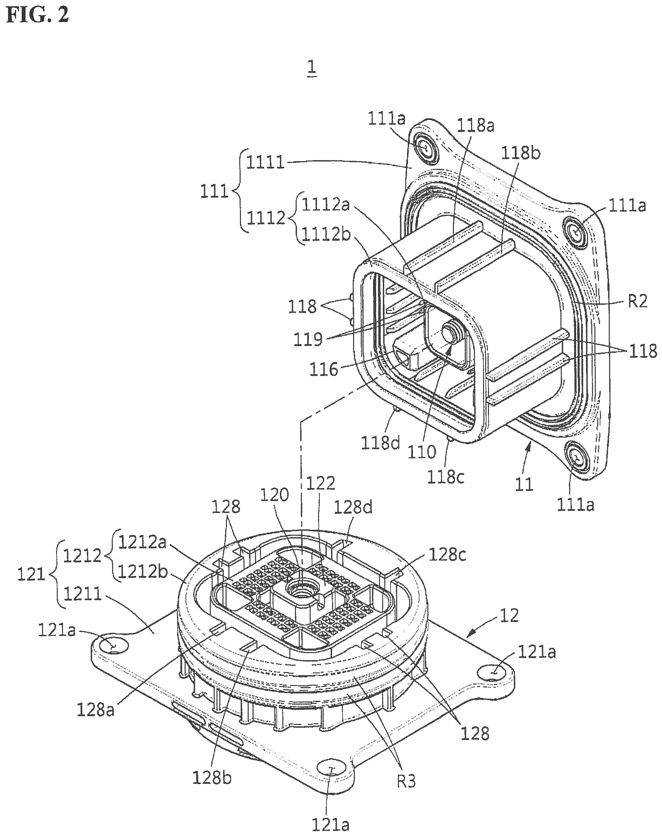

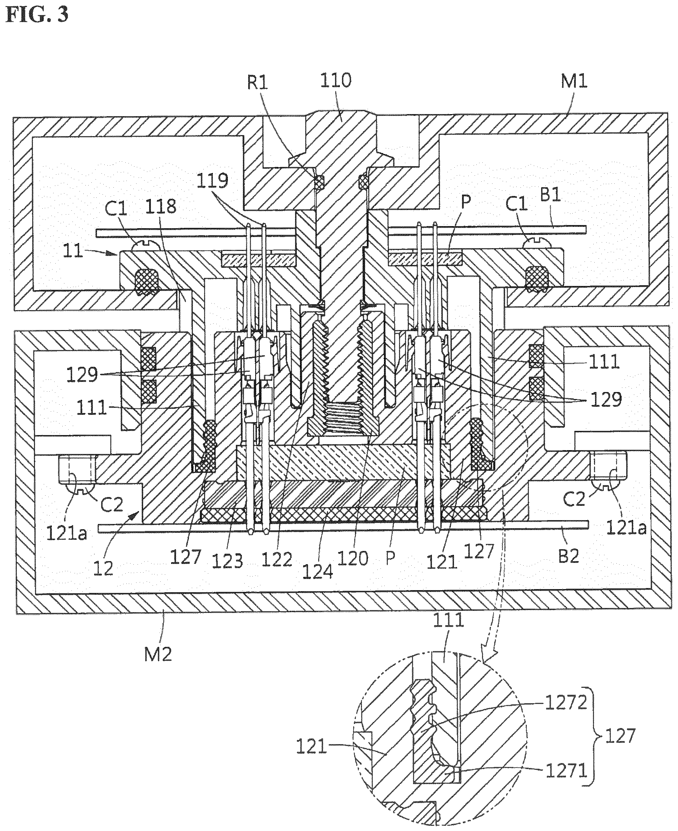

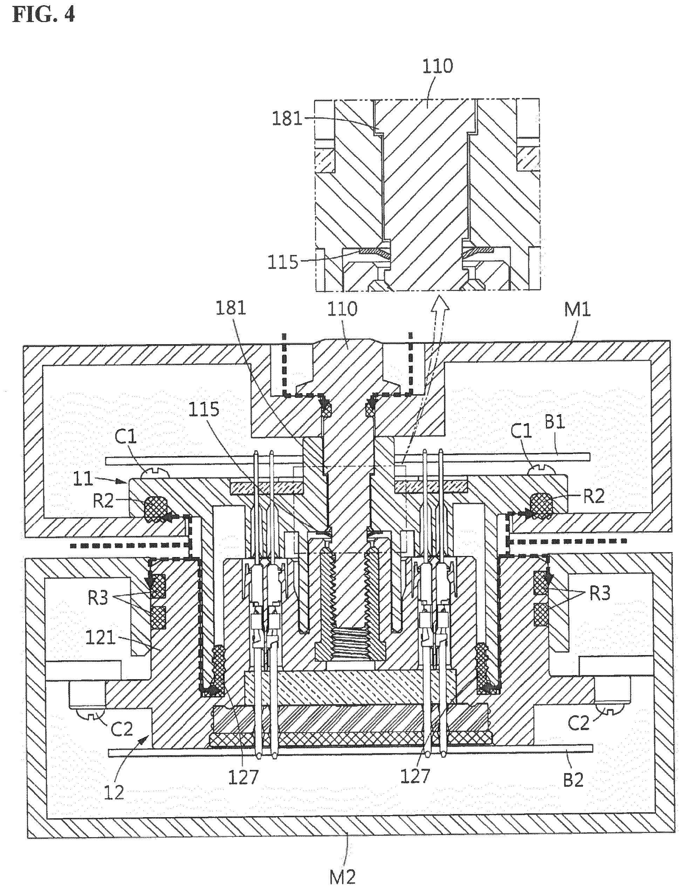

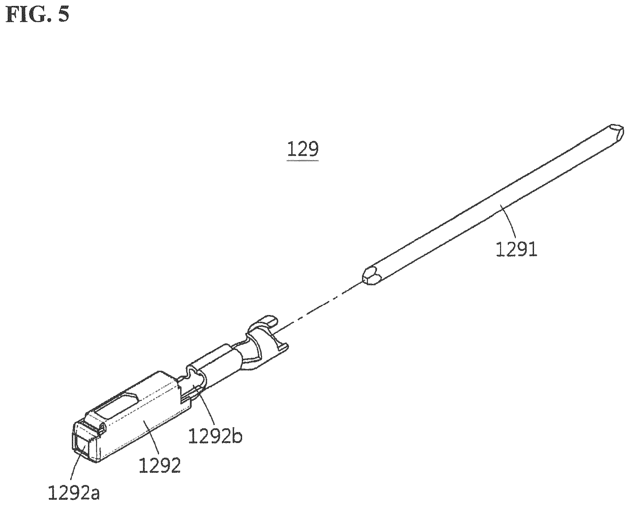

FIG. 1 is a perspective view of a direct coupling connector assembly according to an example embodiment, FIG. 2 is an exploded perspective view of a direct coupling connector assembly according to an example embodiment, FIG. 3 is a cross-sectional view of a direct coupling connector assembly according to an example embodiment, FIG. 4 is a cross-sectional view illustrating a sealing structure of a direct coupling connector assembly according to an example embodiment, and FIG. 5 is an exploded perspective view of a female tap according to an example embodiment.

Referring to FIGS. 1 to 5, a direct coupling connector assembly 1 may implement direct electrical connection between two modules, for example, a first module M1 and a second module M2. The direct coupling connector assembly 1 includes a male connector 11 and a female connector 12 that may be mounted to the first module M1 and the second module M2, respectively. Here, another connector that couples with one connector may be referred to as a "match connector" based on the one connector between the two connectors, for example, the male connector 11 and the female connector 12. According to the above structure, an operator may implement physical and electrical connection between the two modules, for example, the first module M1 and the second module M2 using two connectors, for example, the male connector 11 and the female connector 12 that are assembled to the first module M1 and the second module M2, respectively, without using an intermediate wire coupling operation on the first module M1 and the second module M2. That is, the direct coupling connector assembly 1 does not require a separate module for connection. Through the above operation, the direct coupling connector assembly 1 may physically and electrically connect the two modules, for example, the first module M1 and the second module M2, and may also seal the same from an outside. The direct coupling connector assembly 1 may include the male connector 11 and the female connector 12.

The direct coupling connector assembly 1 may prevent fluid from flowing into the first module M1 to which the male connector 11 is mounted and the second module M2 to which the female connector 12 is mounted. Also, the direct coupling connector assembly 1 may prevent the fluid provided in the first module M1 and the second module M2 from flowing out to the outside.

A coupling O-ring R1 provided to a coupling bolt 110 may be in a shape that surrounds the coupling bolt 110. The coupling bolt 110 may include a coupling groove indented in a direction perpendicular to a lengthwise direction and configured to support the coupling O-ring P1. The coupling O-ring R1 may prevent fluid from flowing into the first module M1 from the outside by sealing between the male connector 11 and the coupling bolt 110.

A male O-ring R2 provided to a male connector body 111 of the male connector 11 may prevent fluid from flowing into the first module M1 through a space between the male connector 11 and the female connector 12 by sealing between the male connector body 111 and the first module M1. For example, the male O-ring R2 may be supported in a state in which at least a portion of the male O-ring R2 is inserted into a male flange 1111 of the male connector body 111.

A female O-ring R3 provided along outer circumference of a female connector body 121 of the female connector 12 may prevent fluid from flowing into the second module M2 through the space between the male connector 11 and the female connector 12 by sealing between the female connector body 121 and the second module M2. For example, the female O-ring R3 may be supported in a state in which at least a portion of the female O-ring R3 is inserted into an outer wall of a female protrusion 1212 of the female connector body 121.

An inner seal 127 may prevent fluid from flowing into the female connector 12 from the outside.

The first module M1 and the second module M2 may require electrical connection. The first module M1 may include a first printed circuit board (PCB) B1, and the second module M2 may include a second PCB B2. The direct coupling connector assembly 1 may connect the first PCB B1 and the second PCB B2. For example, the first module M1 may be a transmission controller unit (TCU) module of a vehicle and the second module M2 may be an electronic module (E-module) that couples with the first module M1. In general, the first module M1 and the second module M2 may be referred to as an electronic module.

The male connector 11 may couple with the female connector 12. The male connector 11 may electrically and physically connect to the first module M1 including the first PCB B1. Likewise, the female connector 12 may electrically and physically connect to the second module M2 including the second PCB B2. Two different modules may be electrically connected through electrical and physical connection between the male connector 11 and the female connector 12. The male connector 11 may include the male connector body 111, a deviation preventer 115, a male body protrusion 116, a plurality of coupling rods 117a and 117b, the coupling bolt 110, a plurality of ribs 118, and a male tap 119.

The male connector body 111 may engage with the female connector 12. The male connector body 111 may slide along the female connector 12 in one direction. The male connector body 111 may support the male tap 119. When the male connector 11 faces the female connector 12 in a coupling direction with the female connector 12, the male tap 119 may be in a line with a female tap 129 provided to the female connector 12. For coupling between the male connector 11 and the female connector 12, the male connector body 111 may protrude toward the female connector 12 further than the male tap 119 based on a state in which the male connector 11 faces the female connector 12. In this case, a portion that surrounds the male tap 119 in the male connector body 111 may initially insert into the female connector 12 rather than the male tap 119. Through the above structure, the male connector body 111 may prevent the male tap 119 from inserting into an erroneous location and thereby being damaged. The male connector body 111 may include a male flange 1111 and a male protrusion 1112.

The male flange 1111 may include a plurality of male bolting holes 111a configured to couple the male connector 11 and the first module M1. For example, a first bolt C1 may fasten the male connector 11 to the first module M1 through screw-connection of the male bolting hole 111a and the first module M1. The male flange 1111 may support the male O-ring R2. The male O-ring R2 may be positioned on one surface of the male flange 1111 that faces the female connector 12.

The male protrusion 1112 may protrude from the male flange 1111 and may insert into the female connector 12. The male protrusion 1112 may include an inner male protrusion 1112a and an outer male protrusion 1112b. The inner male protrusion 1112a may insert into an inner side of an inner female protrusion 1212a of the female connector body 121. That is, the inner male protrusion 1112a may insert between the inner female protrusion 1212a and a coupling nut 120. The outer male protrusion 1112b may insert between the inner female protrusion 1212a and an outer female protrusion 1212b of the female connector body 121.

The deviation preventer 115 may prevent the coupling bolt 110 from being deviated in a first direction, for example, upward in FIG. 4. The deviation preventer 115 may insert into a groove indented between a screw portion and a head portion of the male connector body 111 of the coupling bolt 110. For example, for easy manufacture, the deviation preventer 115 may be present within a space between the coupling nut 120 and a bottom surface of the male connector body 111 based on a state in which the male connector 11 and the female connector 12 are coupled with each other as shown in FIG. 4. Unlike this, the deviation preventer 115 may be formed in the male connector body 111. For example, referring to FIG. 4, the deviation preventer 115 may be a washer that is provided as a part separate from the male connector body 111. The coupling bolt 110 may include a pressing portion 181 formed on an outer wall of the coupling bolt 110 and configured to press the male connector body 111 and to prevent the coupling bolt 110 from being deviated in a second direction, for example, downward FIG. 4, which is opposite to the first direction. For example, the pressing portion 181 may be received in a stepped portion that is formed in the male connector body 111 and may prevent the coupling bolt 110 from being deviated in the second direction. The deviation preventer 115 and the pressing portion 181 may assist the coupling bolt 110 to be rotatable in place relative to the male connector body 111.

The male body protrusion 116 may protrude from the male flange 1111 between the inner male protrusion 1112a and the outer male protrusion 1112b, and may insert into a groove formed in the inner female protrusion 1212a. The male body protrusion 116 may assist the male tap 119 and the female tap 129 to couple with each other in an aligned state. An end of the male body protrusion 116 that is most distant from the male flange 1111 may have a shape that becomes narrower in a direction away from the male flange 1111. According to the above shape, the male body protrusion 116 may be easily inserted into the inner female protrusion 1212a although the male body protrusion 116 is not accurately aligned with the inner female protrusion 1212a.

The outer male protrusion 1112b may primarily guide an insertion direction of the male tap 119, the inner male protrusion 1112a may secondly guide the insertion direction of the male tap 119, and the male body protrusion 116 may thirdly guide the insertion direction of the male tap 119. Through the above structure, it is possible to prevent the male tap 119 from being deformed due to the end of the female tap 129 in response to coupling between the male connector 11 and the female connector 12.

A plurality of coupling rods 117a and 117b may protrude from the male connector body 111, and may be in a line with the plurality of male taps 119. For example, the plurality of coupling rods 117a and 117b may include a first coupling rod 117a and a second coupling rod 117b each having a different diameter. A diameter of the first coupling rod 117a may be less than a diameter of the second coupling rod 117b. For example, the first PCB B1 mounted to the male connector 11 may include holes, each having a different diameter, through which the first coupling rod 117a and the second coupling rod 117b may pass. The plurality of coupling rods 117a and 117b may prevent the first PCB B1 from being erroneously assembled to the male connector 11.

A plurality of ribs 118 may protrude from a sidewall of the male connector body 111. For example, when the male connector 11 is structured to be inserted into an inner side of the female connector 12, each of the plurality of ribs 118 may be in a shape that protrudes outward from the outer wall of the male connector body 111. When the male connector 11 is inserted into an outer side of the female connector 12, that is, when the male connector 11 is structured to surround and couple with the female connector 12, the plurality of ribs 118 may protrude inward from the inner wall of the male connector body 111. The female connector 12 may include a plurality of rib receiving grooves 128 configured to receive the plurality of ribs 118, respectively. The plurality of ribs 118 may slide along the plurality of rib receiving grooves 128, respectively.

Among at least a portion of the plurality of ribs 118, an interval between neighboring ribs may differ from an interval between another neighboring ribs. For example, the plurality of ribs 118 may include a first rib 118a and a second rib 118b formed on a first sidewall of the male connector body 111 and a third rib 118c and a fourth rib 118d formed on a second sidewall of the male connector body 111. An interval between the first rib 118a and the second rib 118b may be greater than or less than an interval between the third rib 118c and the fourth rib 118d. Through the above structure, it is possible to prevent the male connector 11 and the female connector 12 from being coupled in an erroneous orientation with respect to each other i.e. not in an originally intended relative orientation.

Although description is made based on an example in which the plurality of ribs 118 is formed on the male connector 11, it is provided as an example. For example, the female connector 12 may include a plurality of ribs and the male connector 11 may include a plurality of rib receiving grooves. As another example, the male connector 11 may include a plurality of ribs and a plurality of rib receiving grooves and the female connector 12 may include a plurality of rib receiving grooves and a plurality of ribs corresponding thereto.

The male tap 119 may be provided to the male connector body 111. The male tap 119 may pass through the male connector body 111. One end of the male tap 119 may connect to the first PCB B1 that is provided in the first module M1. The male tap 119 may directly couple with the female tap 129 that is provided in the female connector 12. A plurality of male taps 119 may be provided. The male tap 119 may electrically connect to the first PCB B1 that is connected to the male connector body 111, and a potting material P may be potted on a portion that penetrates the male connector body 111 for waterproofing.

The coupling bolt 110 may connect to the male connector 11 to be rotatable in place, and may couple the male connector 11 and the female connector 12. The coupling bolt 110 may perform screw-connection with the coupling nut 120 of the female connector 12.

Hereinafter, description is made based on a state in which the male connector 11 is fastened so as to be immovable relative to the first module M1 and the female connector 12 is fastened so as to be immovable relative to the second module M2.

When the coupling bolt 110 rotates in one direction through engagement with the coupling nut 120, the coupling bolt 110 may move to get closer to the female connector 12 along the coupling nut 120 and the pressing portion 181 of the coupling bolt 110 may press the stepped portion that is formed in the male connector body 111. In this manner, the male connector 11 and the female connector 12 may couple with each other. During the above process, the first module M1 and the second module M2 fastened to the male connector 11 and the female connector 12, respectively, may move to get closer to each other and may be physically and electrically connected.

On the other hand, when the coupling bolt 110 rotates in a direction opposite to the one direction, the coupling bolt 110 may move to be distant from the female connector 12 and the deviation preventer 115 inserted into the indented groove of the coupling bolt 110 may lift or displace the male connector body 111 to become distant or further from the female connector 12. In this manner, coupling between the male connector 11 and the female connector 12 may be released. During the above process, the first module M1 and the second module M2 fastened to the male connector 11 and the female connector 12, respectively, may move away from each other and may be physically and electrically disconnected.

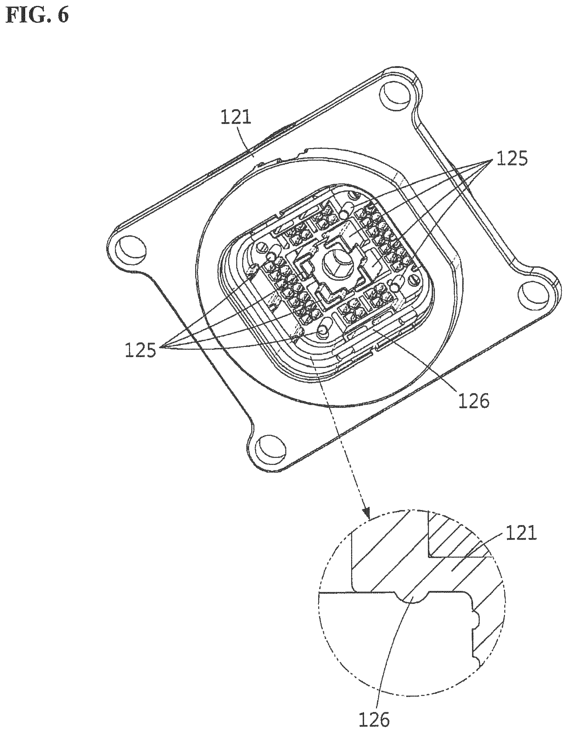

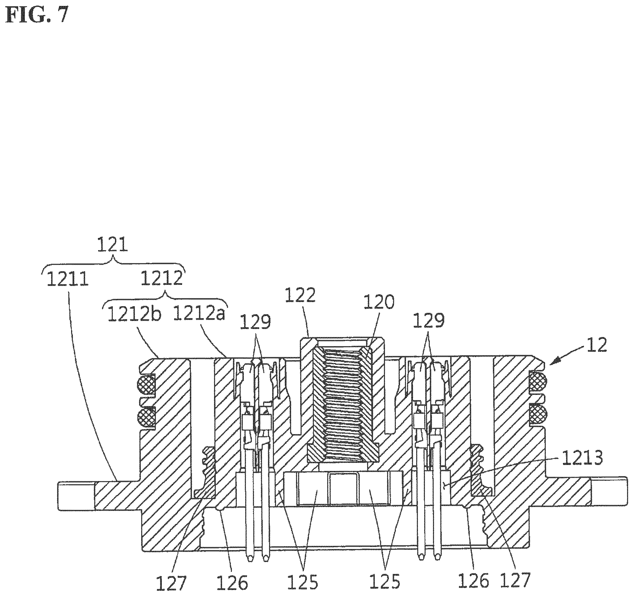

The female connector 12 may include the female connector body 121, a support 122, a family or multi-contact combined seal 123, a seal holder 124, a support rod 125 (see FIG. 7), a protrusion 126 (see FIG. 7), the inner seal 127, the coupling nut 120, the plurality of rib receiving grooves 128, and the female tap 129. The seal holder 124, the support rod 125, and the protrusion 126 will be further described with reference to FIGS. 6 to 8.

The female connector body 121 may engage with the male connector body 111. The female connector body 121 may slide along the male connector body 111 in one direction. The female connector body 121 may support the female tap 129. For coupling between the female connector 12 and the male connector 11, the female connector body 121 may protrude toward the male connector 11 further than the female tap 129 based on a state in which the female connector 12 faces the male connector 11. The female connector body 121 may include a female flange 1211, the female protrusion 1212, and a female potting portion 1213 (see FIG. 7).

The female flange 1211 may include a plurality of female bolting holes 121a configured to couple the female connector 12 and the second module M2. For example, a second bolt C2 may fasten the female connector 12 to the second module M2 through screw-connection of the female bolting hole 121a and the second module M2.

The female protrusion 1212 protrudes from the female flange 1211 and may insert into the male connector 11. The female protrusion 1212 may include a groove for supporting the female O-ring R3 on an outer wall. The female protrusion 1212 may include the inner female protrusion 1212a and the outer female protrusion 1212b.

The inner female protrusion 1212a is separate from the support 122 and is in a shape that surrounds an outer side of the support 122 and protrudes from the female flange 1211.

The outer female protrusion 1212b is separate from the inner female protrusion 1212a and is in a shape that surrounds an outer side of the inner female protrusion 1212a and protrudes from the female flange 1211.

Referring to FIG. 7, the female potting portion 1213 may be provided in a space between the female protrusion 1212 and the family seal 123. In a state in which the family seal 123 is provided to close one surface of the female potting portion 1213, the potting material P may be potted on the female potting portion 1213.

The support 122 is provided to the female connector body 121. The support 122 is also provided at a center of the female connector body 121. The support 122 may protrude highest from a center of the female flange 1211 and supports the coupling nut 120 and may guide the coupling bolt 110. The inner seal 127 is provided to the female connector body 121 and may be in contact with at least a portion of the male connector body 111. For example, the inner seal 127 may be provided in a portion of the female connector body 121 into which the male connector body 111 is inserted. The inner seal 127 may be in a ring shape. While the coupling bolt 110 is moving toward the female connector 12 by rotating through engagement with the coupling nut 120, the inner seal 127 may be pressed and compressed by the male connector body 111. The inner seal 127 may be formed of a flexible material having elasticity. The inner seal 127 prevents fluid from penetrating between the male connector 11 and the female connector 12. The inner seal 127 may include a first seal part 1271 and a second seal part 1272. The inner seal 127 may insert into the female connector body 121 in an extended state. The inner seal 127 may further closely attach to the female connector body 121 with a resiling force. For example, the inner seal 127 may be in a closed-ring shape and thereby may prevent fluid from flowing into the female connector body 121 from the outside in all directions.

The first seal part 1271 may be in contact with one end of the male connector 11, for example, the male protrusion 1112. For example, the first seal part 1271 may be in contact with the outer male protrusion 1112b. For example, the first seal part 1271 may be provided on the female connector body 121 in a direction perpendicular to a coupling direction of the male connector 11. The first seal part 1271 may absorb a vibration in a direction parallel to a coupling direction among vibrations that are transferred from the male connector body 111 to the female connector body 121, or transferred from the female connector body 121 to the male connector body 111.

The second seal part 1272 may extend perpendicularly from the first seal part 1271, and may be in contact with the male connector 11, for example, the inner wall of the male protrusion 1112. For example, the second seal part 1272 may be in contact with the inner wall of the outer male protrusion 1112b. The second seal part 1272 may be provided along one surface of the female connector body 121. The second seal part 1272 may be provided in an inner side of the male connector body 111 when the male connector body 111 couples with the female connector body 121. The second seal part 1272 may be deformed to be inward due to the male connector body 111. The second seal part 1272 may absorb a vibration in a crossing direction relative to the coupling direction among vibrations that are transferred from the male connector body 111 to the female connector body 121, or transferred from the female connector body 121 to the male connector body 111.

The aforementioned shape of the inner seal 127 is provided as an example only. For example, based on a cross-section of the inner seal 127, an outer portion of the inner seal 127 may be in a further protruding shape compared to an inner portion of the inner seal 127. Alternatively, the inner portion and the outer portion of the inner seal 127 may be in a further protruding shape compared to a center portion of the inner seal 127.

The plurality of rib receiving grooves 128 may receive the plurality of ribs 118, respectively. The plurality of rib receiving grooves 128 may include, for example, a first rib receiving groove 128a, a second rib receiving groove 128b, a third rib receiving groove 128c, and a fourth rib receiving groove 128d. An interval between the first rib receiving groove 128a and the second rib receiving groove 128b may be greater than an interval between the third rib receiving groove 128c and the fourth rib receiving groove 128d.

The female tap 129 may be provided to the female connector body 121. The female tap 129 may pass through the female connector body 121. One end of the female tap 129 may connect to the second PCB B2 that is provided in the second module M2. The female tap 129 may directly couple with the male tap 119 that is provided in the male connector 11. A plurality of female taps 129 may be provided. The female tap 129 may electrically connect to the second PCB B2 that is connected to the female connector body 121. The female tap 129 may include a pin 1291 and a receptor 1292.

The pin 1291 may be in an elongated bar shape. For example, both ends of the male tap 119 may be configured using a pin only. The pin 1291 may directly connect to the second PCB B2, and may be supported by the female connector body 121.

The receptor 1292 may connect to an end of the pin 1291 and may receive at least a portion of the male tap 119. For example, the receptor 1292 may include an opening part 1292a configured to connect to the male tap 119 and a fastening part 1292b configured to become narrower in a direction away from the opening part 1292a and to fasten to the pin 1291. The fastening part 1292b may be fastened with the pin 1291 through pressing or soldering.

Although description is made based on an example in which the female tap 129 includes the pin 1291 and the receptor 1292, and the male tap 119 is configured using a pin, it is provided as an example only. For example, the male tap 119 may include a pin and a receptor, and the female tap 129 may include a pin.

The coupling nut 120 may be provided to the female connector body 121, and may perform screw-connection with the coupling bolt 110. For example, the coupling nut 120 may be a nut.

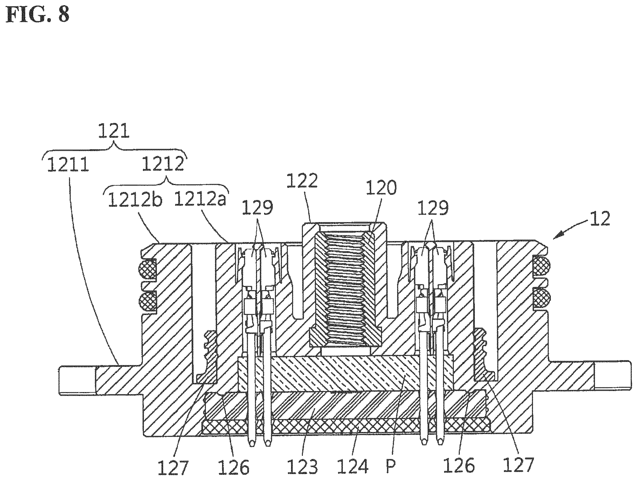

FIG. 6 is a bottom view of a female connector according to an example embodiment, FIG. 7 is a cross-sectional view of a female connector and illustrates a state in which a family seal and a seal holder are separate according to an example embodiment, and FIG. 8 is a cross-sectional view of a female connector according to an example embodiment.

Referring to FIGS. 6 to 8, the female connector 12 may include the female connector body 121, the family seal 123, the seal holder 124, the support rod 125, the inner seal 127, and the female tap 129.

The family seal 123 may be inserted into the female connector body 121. The family seal 123 may have elasticity and may be pressed and thereby compressed by the female connector body 121 in response to being inserted into the female connector body 121. The family seal 123 may include a plurality of holes configured to support the female tap 129. A cross-sectional area of the plurality of holes may be less than that of the female tap 129. When the female tap 129 passes through the family seal 123, the family seal 123 may be compressed and the female tap 129 may be pressed by the family seal 123. The family seal 123 may seal the female connector body 121 to prevent the potting material P from leaking to the outside while the potting material P is being injected into the female connector body 121.

The seal holder 124 may be positioned in the female connector body 121 and may support the family seal 123. The seal holder 124 may prevent the family seal 123 from being separate from the female connector body 121. The seal holder 124 may include a plurality of holes configured to support the female tap 129. A cross-sectional area of the seal holder 124 may be greater than or equal to that of the female tap 129. The seal holder 124 may be formed using a rigid material compared to that of the family seal 123. Through the above structure, the seal holder 124 may assist the female tap 129 to be capable of further physically readily coupling with the male tap 119 by accurately aligning a position of the female tap 129.

The support rod 125 may protrude from the female connector body 121 and may support the family seal 123. The support rod 125 may protrude from the female connector body 121 in a direction opposite to a direction in which the female connector 12 faces the male connector 11. That is, the support rod 125 may protrude from the female connector body 121 in a direction extending away from the male connector 11. The female potting portion 1213 may be provided in a space between the family seal 123 and the female connector body 121 by way of the support rod 125. The potting material P may fill in the female potting portion 1213. A plurality of support rods 125 may be provided. The plurality of support rods 125 may be separate from each other. The potting material P injected into the female connector body 121 may flow between the plurality of support rods 125.

The protrusion 126 may protrude from the female connector body 121 and may be inserted into the family seal 123. The protrusion 126 may be, for example, in a ring-shaped protrusion. The protrusion 126 may be inserted into the family seal 123 and may provide further secure sealing between the female connector body 121 and the family seal 123. The family seal 123 may include a groove in a shape corresponding to a shape of the protrusion 126.

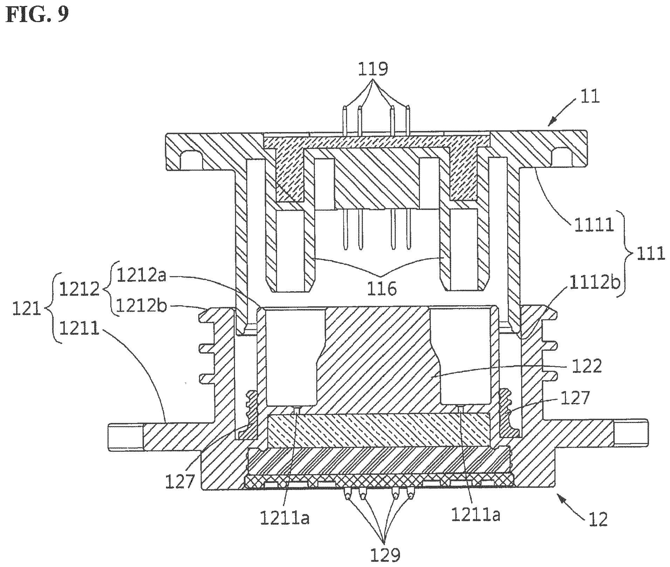

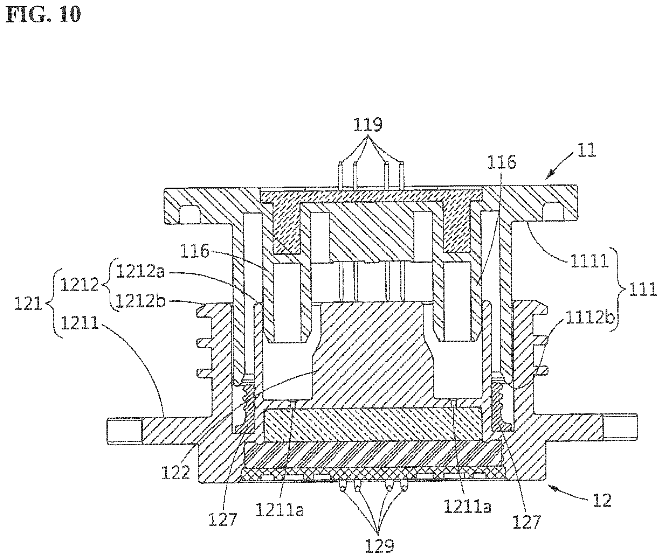

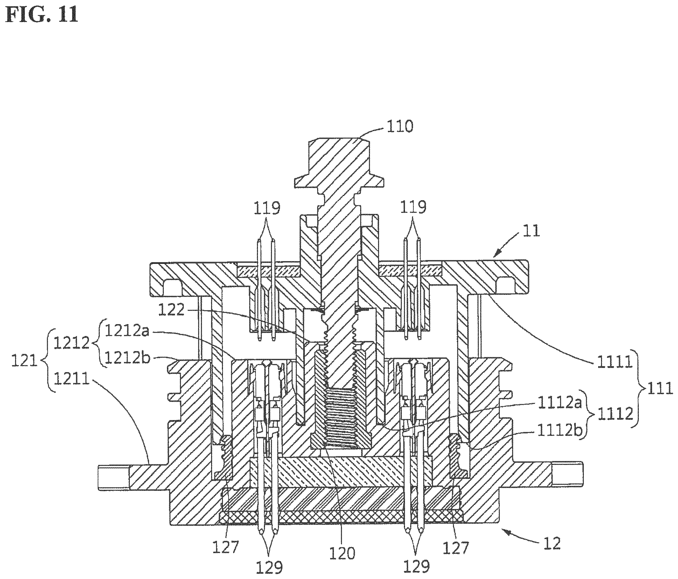

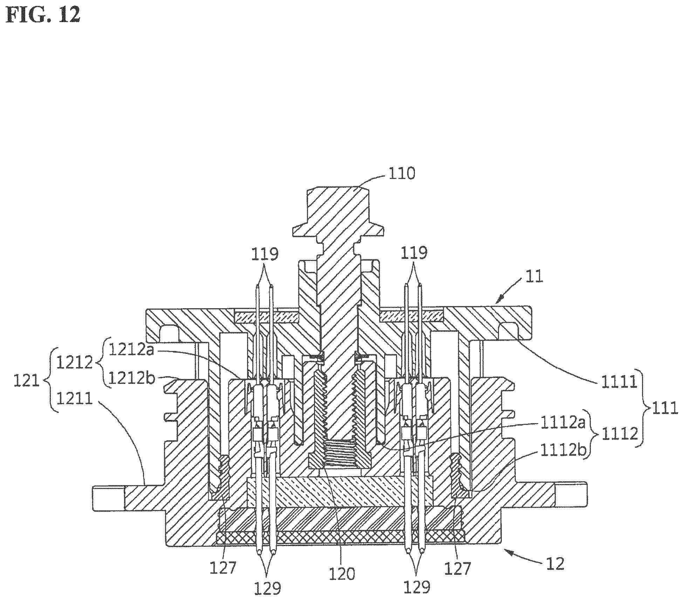

FIGS. 9 through 12 are cross-sectional views of a direct coupling connector assembly according to an example embodiment. FIG. 9 illustrates a state in which the male connector 11 and the female connector 12 are not in contact with each other, FIG. 10 illustrates a state in which a portion of the male connector body 111 is in contact with a portion of the female connector body 121, FIG. 11 illustrates a state in which the coupling bolt 110 is received in the coupling nut 120, and FIG. 12 illustrates a state in which the coupling bolt 110 has been rotated and the male connector 11 and the female connector 12 are completely coupled.

Referring to FIGS. 9 to 12, the female connector body 121 may include a plurality of body holes 1211a. The plurality of body holes 1211a may be provided to face the seal holder 124 based on the family seal 123, and may be formed to penetrate the female connector body 121 in a direction perpendicular to the family seal 123.

The plurality of body holes 1211a may be provided, for example, in a circumferential direction of the support 122 based on the support 122. The user may verify whether an appropriate amount of potting material fills in the female potting portion 1213 through the plurality of body holes 1211a. For example, four or more body holes 1211a may be provided in the circumferential direction of the support 122 based on the support 122. In a state in which the seal holder 124 is inserted into the female connector body 121, the user may observe the remaining body hole(s) 1211a while filling the potting material in the female connector body 121 through one or more body holes 1211a. Once a sufficient amount of potting material fills in a lower portion of each of the plurality of body hole 1211a, the potting material may pass through the body hole 1211a. The user may initially verify whether the potting material passes the four body holes 1211a and then determine whether the potting material appropriately fills therein. In addition, the potting material flows over the body hole 1211a and may form a buffing portion with a predetermined thickness in an inner side of the female connector body 121 in a portion that contacts with the male connector body 111, thereby preventing a vibration of the female connector 12.

The male connector 11 and the female connector 12 may gradually couple with each other as follows:
Referring to FIG. 9, the outer male protrusion 1112b may be inserted along an inner side of the outer female protrusion 1212b. During this process, the male tap 119 and the female tap 129 may be aligned. The user may easily recognize a coupling orientation based on the shape of the outer male protrusion 1112b and the outer female protrusion 1212b, for example, the plurality of ribs 118 and the plurality of rib receiving grooves 128 (see FIG. 2. The outer female protrusion 1112b may be separate from the inner female protrusion 1212a. The male tap 119 may approach the female tap 129. Here, the male body protrusion 116 may not be in contact with the female connector 12. As described above, prior to this operation, appropriate filling of the potting material may be verified through the body hole 1211a. Although not illustrated, the male flange 1111 and the female flange 1211 may be installed in different modules, respectively.

Referring to FIG. 10, the male body protrusion 116 may be inserted into the inner female protrusion 1212a. During this process, the male tap 119 and the female tap 129 may be further accurately aligned.

Referring to FIG. 11, an end of the coupling bolt 110 may be received in the coupling nut 120. During this process, the male tap 119 and the female tap 129 may be further accurately aligned.

Referring to FIG. 12, as the coupling bolt 110 is rotated relative to the male connector 11, the male connector 11 and the female connector 12 may couple with each other. During progress of coupling, the male tap 119 may insert into the female tap 129.

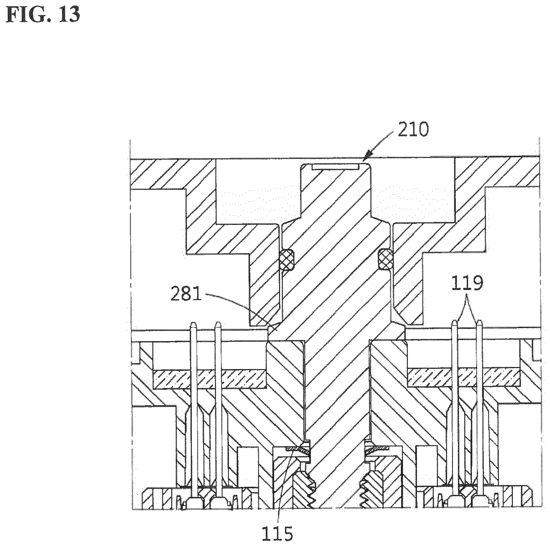

FIG. 13 is a partially enlarged cross-sectional view of a direct coupling connector assembly according to an example embodiment. A remaining portion not illustrated in FIG. 13 may refer to FIG. 3.

Referring to FIG. 13, a coupling bolt 210 may include a pressing portion 281 configured to protrude from an outer wall. The pressing portion 281 may prevent the coupling bolt 210 from being deviated in one direction, for example, downward in FIG. 13. For example, the pressing portion 281 may be received on a top surface of the male connector body 111 and may prevent the coupling bolt 210 from being deviated in a second direction, for example, downward in FIG. 13. The deviation preventer 115 and the pressing portion 281 may assist the coupling bolt 210 to be rotatable in place relative to the male connector body 111.

## Claims

1. A direct coupling connector assembly (1) comprising a male connector (11) mountable to a first module (M1) provided with a first printed circuit board (PCB) (B1), and a female connector (12) mountable to a second module (M2) provided with a second PCB (B2), wherein:
the male connector (11) comprises a male connector body (111) comprising a male flange (1111) and a male protrusion (1112) protruding from the male flange (1111), a plurality of male contacts (119) which penetrate the male connector body (111) and are connectable to the first PCB (B1), a coupling bolt (110) configured to be connected to the male connector (11) so as to be rotatable in place, and a male O-ring (R2) recessed into the male flange (1111); and
the female connector (12) comprises a female connector body (121) comprising a female flange (1211) and a female protrusion (1212) protruding from the female flange (1211), a plurality of female contacts (129) each comprising a pin (1291) which penetrate through the female connector body (121) and are connectable to the second PCB (B2) and a receptor (1292) connected to an end of the pin (1291), an inner seal (127) provided in the female protrusion (1212) and configured to be in contact with at least a portion of the male connector (11), a coupling nut (120) provided in the female connector body (121), a female O-ring (R3) recessed into an outer wall of the female protrusion (1212), and
a support (122) protruding from a center of the female flange (1211) and supporting the coupling nut (120), wherein the female protrusion (1212) comprises:
an inner female protrusion (1212a) separate from the support (122) and surrounding an outer side of the support (122), and protruding from the female flange (1211); and an outer female protrusion (1212b) separate from the inner female protrusion (1212a) and surrounding the inner female protrusion (1212a),
the male protrusion (1112) comprising:
an inner male protrusion (1112a) separate from the coupling bolt (110), protruding from the male flange (1111) and configured to be inserted into an inner side of the inner female protrusion (1212a);
an outer male protrusion (1112b) insertable between the inner female protrusion (1212a) and the outer female protrusion (1212b); and
a coupling O-ring (R1) surrounding the coupling bolt (110), the coupling bolt (110) comprising a coupling groove indented in a direction perpendicular to a lengthwise direction of the coupling bolt (110) and supporting the coupling O-ring (R1).

2. The direct coupling connector assembly (1) of claim 1, wherein the inner seal (127) comprises:
a first seal part (1271) configured to be in contact with the male protrusion (1112); and
a second seal part (1272) configured to extend perpendicularly from the first seal part (1271) and to be in contact with an inner wall of the male protrusion (1112).

3. The direct coupling connector assembly (1) of claims 1 or 2, wherein the female connector (12) comprises:
a multi-contact seal (123) inserted into the female connector body (121) and supporting the plurality of female contacts (129); and
a seal holder (124) inserted into the female connector body (121), supporting the multi-contact seal (123), and supporting the plurality of female contacts (129).

4. The direct coupling connector assembly (1) of claim 3, wherein the female connector (12) further comprises a female potting portion (P) provided in a space between the female protrusion (1212) and the multi-contact seal (123).

5. The direct coupling connector assembly (1) of claim 4, wherein the female connector body (121) comprises a plurality of body holes (211a) which penetrate the female connector body (121) in a direction perpendicular to the multi-contact seal (123) and open into the space between the female protrusion (1212) and the multi-contact seal (123).

6. The direct coupling connector assembly (1) of any preceding claim, wherein the male connector (11) further comprises a deviation preventer (115) configured to prevent the coupling bolt (110) from being displaced in a first direction relative to the male connector body (111), and
the coupling bolt (110) comprises a pressing portion (181) formed on an outer wall of the coupling bolt (110) and configured to press the male connector body (111) and to prevent the coupling bolt (110) from being displaced in a second direction that is opposite to the first direction.

7. The direct coupling connector assembly (1) of claim 1, wherein one of the male connector (11) and the female connector (12) comprises a plurality of ribs (118) configured to be inserted into the other connector, and
a gap between two neighboring said ribs (118a, 118b) differs from a gap between another two neighboring said ribs (118c, 118d).

## Patentansprüche

1. Direktkupplungsverbinderanordnung (1), die einen Steckverbinder (11), der an einem ersten Modul (M1) montierbar ist, das mit einer ersten Leiterplatte (PCB) (B1) versehen ist, und einen Aufnahmeverbinder (12) umfasst, der an einem zweiten Modul (M2) montierbar ist, das mit einer zweiten PCB (B2) versehen ist, wobei:
der Steckverbinder (11) Folgendes umfasst: einen Steckverbinderkörper (111) mit einem Steckflansch (1111) und einem vom Steckflansch (1111) vorstehenden Steckvorsprung (1112), mehrere Steckkontakte (119), die in den Steckverbinderkörper (111) eindringen und mit der ersten PCB (B1) verbunden werden können, einen Kupplungsschraubbolzen (110), der zum Verbinden mit dem Steckverbinder (11) konfiguriert ist, so dass er an Ort und Stelle drehbar ist, und einen in den Steckflansch (1111) eingelassenen Steck-O-Ring (R2); und
der Aufnahmeverbinder (12) Folgendes umfasst: einen Aufnahmeverbinderkörper (121) mit einem Aufnahmeflansch (1211) und einem vom Aufnahmeflansch (1211) vorstehenden Aufnahmevorsprung (1212), mehrere Aufnahmekontakte (129) jeweils mit einem Stift (1291), der in den Aufnahmeverbinderkörper (121) eindringt und mit der zweiten PCB (B2) verbunden werden kann, und einen mit einem Ende des Stifts (1291) verbundenen Rezeptor (1292), eine innere Dichtung (127), die im Aufnahmevorsprung (1212) vorgesehen und so konfiguriert ist, dass sie mit mindestens einem Abschnitt des Steckverbinders (11) in Kontakt steht, eine im Aufnahmeverbinderkörper (121) vorgesehene Kupplungsmutter (120), einen Aufnahme-O-Ring (R3), der in eine Außenwand des Aufnahmevorsprungs (1212) eingelassen ist, und
eine Stütze (122), die von einer Mitte des Aufnahmeflanschs (1211) vorsteht und die Kupplungsmutter (120) stützt, wobei der Aufnahmevorsprung (1212) Folgendes umfasst:
einen inneren Aufnahmevorsprung (1212a), der von der Stütze (122) separat ist und eine Außenseite der Stütze (122) umgibt und vom Aufnahmeflansch (1211) vorsteht;
und einen äußeren Aufnahmevorsprung (1212b), der vom inneren Aufnahmevorsprung (1212a) separat ist und den inneren Aufnahmevorsprung (1212a) umgibt, wobei der Steckvorsprung (1112) Folgendes umfasst:
einen inneren Steckvorsprung (1112a) separat vom Kupplungsschraubbolzen (110), der vom Steckflansch (1111) vorsteht und zum Einsetzen in eine Innenseite des inneren Aufnahmevorsprungs (1212a) konfiguriert ist;
einen äußeren Steckvorsprung (1112b), der zwischen dem inneren Aufnahmevorsprung (1212a) und dem äußeren Aufnahmevorsprung (1212b) eingesetzt werden kann; und
einen Kupplungs-O-Ring (R1), der den Kupplungsschraubbolzen (110) umgibt, wobei der Kupplungsschraubbolzen (110) eine Kupplungsnut aufweist, die in einer Richtung lotrecht zu einer Längsrichtung des Kupplungsschraubbolzens (110) vertieft ist und den Kupplungs-O-Ring (R1) stützt.

2. Direktkupplungsverbinderanordnung (1) nach Anspruch 1, wobei die innere Dichtung (127) Folgendes umfasst:
einen ersten Dichtungsteil (1271), der so konfiguriert ist, dass er mit dem Steckvorsprung (1112) in Kontakt ist; und
einen zweiten Dichtungsteil (1272), der so konfiguriert ist, dass es sich lotrecht vom ersten Dichtungsteil (1271) erstreckt und mit einer Innenwand des Steckvorsprungs (1112) in Kontakt ist.

3. Direktkupplungsverbinderanordnung (1) nach Anspruch 1 oder 2, wobei der Aufnahmeverbinder (12) Folgendes umfasst:
eine Mehrfachkontaktdichtung (123), die in den Aufnahmeverbinderkörper (121) eingesetzt ist und die mehreren Aufnahmekontakte (129) stützt; und
einen Dichtungshalter (124), der in den Aufnahmeverbinderkörper (121) eingesetzt ist, die Mehrfachkontaktdichtung (123) stützt und die mehreren Aufnahmekontakte (129) stützt.

4. Direktkupplungsverbinderanordnung (1) nach Anspruch 3, wobei der Aufnahmeverbinder (12) ferner einen Aufnahmevergussteil (P) umfasst, der in einem Raum zwischen dem Aufnahmevorsprung (1212) und der Mehrfachkontaktdichtung (123) vorgesehen ist.

5. Direktkupplungsverbinderanordnung (1) nach Anspruch 4, wobei der Aufnahmeverbinderkörper (121) mehrere Körperlöcher (211a) aufweist, die in den Aufnahmeverbinderkörper (121) in einer Richtung lotrecht zur Mehrfachkontaktdichtung (123) eindringen und in den Raum zwischen dem Aufnahmevorsprung (1212) und der Mehrfachkontaktdichtung (123) öffnen.

6. Direktkupplungsverbinderanordnung (1) nach einem vorherigen Anspruch, wobei der Steckverbinder (11) ferner eine Ablenkungsschutz (115) umfasst, der konfiguriert ist zum Verhindern, dass der Kupplungsschraubbolzen (110) in einer ersten Richtung relativ zum Steckverbinderkörper (111) verschoben wird, und
der Kupplungsschraubbolzen (110) einen Druckteil (181) umfasst, der an einer Außenwand des Kupplungsschraubbolzens (110) ausgebildet und konfiguriert ist zum Drücken gegen den Steckverbinderkörper (111) und zum Verhindern, dass der Kupplungsschraubbolzen (110) in einer zweiten Richtung, die der ersten Richtung entgegengesetzt ist, verschoben wird.

7. Direktkupplungsverbinderanordnung (1) nach Anspruch 1, wobei der Steckverbinder (11) oder der Aufnahmeverbinder (12) mehrere Rippen (118) umfasst, die zum Einsetzen in den anderen Verbinder konfiguriert sind, und
ein Spalt zwischen zwei benachbarten genannten Rippen (118a, 118b) sich von einem Spalt zwischen zwei anderen benachbarten genannten Rippen (118c, 118d) unterscheidet.

## Revendications

1. Ensemble connecteur à couplage direct (1) comprenant un connecteur mâle (11) apte à être monté sur un premier module (M1) doté d'une première carte à circuits imprimés (CCI) (B1), et un connecteur femelle (12) apte à être monté sur un deuxième module (M2) doté d'une deuxième CCI (B2), dans lequel :
le connecteur mâle (11) comprend un corps de connecteur mâle (111) comprenant une bride mâle (1111) et une saillie mâle (1112) faisant saillie à partir de la bride mâle (1111), une pluralité de contacts mâles (119) qui pénètrent dans le corps de connecteur mâle (111) et sont aptes à être connectés sur la première CCI (B1), un boulon de couplage (110) configuré pour être connecté au connecteur mâle (11) de sorte à pouvoir être tourné en place, et un joint torique mâle (R2) encastré dans la bride mâle (1111) ; et
le connecteur femelle (12) comprend un corps de connecteur femelle (121) comprenant une bride femelle (1211) et une saillie femelle (1212) faisant saillie à partir de la bride femelle (1211), une pluralité de contacts femelles (129) chacun comprenant une broche (1291) qui pénètrent à travers le corps de connecteur femelle (121) et sont aptes à être connectés sur la deuxième CCI (B2), et un récepteur (1292) connecté sur une extrémité de la broche (1291), un joint interne (127) prévu dans la saillie femelle (1212) et configuré pour être en contact avec au moins une portion du connecteur mâle (11), un écrou de couplage (120) prévu dans le corps de connecteur femelle (121), un joint torique femelle (R3) encastré dans une paroi externe de la saillie femelle (1212), et
un support (122) faisant saillie à partir d'un centre de la bride femelle (1211) et soutenant l'écrou de couplage (120), dans lequel la saillie femelle (1212) comprend :
une saillie femelle interne (1212a) séparée du support (122) et entourant un côté externe du support (122), et faisant saillie à partir de la bride femelle (1211) ;
et une saillie femelle externe (1212b) séparée de la saillie femelle interne (1212a) et entourant la saillie femelle interne (1212a),
la saillie mâle (1112) comprenant :
une saillie mâle interne (1112a) séparée du boulon de couplage (110), faisant saillie à partir de la bride mâle (1111) et configurée pour être insérée dans un côté interne de la saillie femelle interne (1212a) ;
une saillie mâle externe (1112b) insérable entre la saillie femelle interne (1212a) et la saillie femelle externe (1212b) ; et
un joint torique de couplage (R1) entourant le boulon de couplage (110), le boulon de couplage (110) comprenant une rainure de couplage avec une indentation dans un sens perpendiculaire à un sens de la longueur du boulon de couplage (110) et soutenant le joint torique de couplage (R1) .

2. Ensemble connecteur à couplage direct (1) de la revendication 1, dans lequel le joint interne (127) comprend :
une première partie de joint (1271) configurée pour être en contact avec la saillie mâle (1112) ; et
une deuxième partie de joint (1272) configurée pour s'étendre perpendiculairement à partir de la première partie de joint (1271) et pour être en contact avec une paroi interne de la saillie mâle (1112).

3. Ensemble connecteur à couplage direct (1) des revendications 1 ou 2, dans lequel le connecteur femelle (12) comprend :
un joint de contacts multiples (123) inséré dans le corps de connecteur femelle (121) et soutenant la pluralité de contacts femelles (129) ; et
un dispositif de maintien de joint (124) inséré dans le corps de connecteur femelle (121), soutenant le joint de contacts multiples (123), et soutenant la pluralité de contacts femelles (129).

4. Ensemble connecteur à couplage direct (1) de la revendication 3, dans lequel le connecteur femelle (12) comprend en outre une portion d'enrobage femelle (P) prévue dans un espace entre la saillie femelle (1212) et le joint de contacts multiples (123).

5. Ensemble connecteur à couplage direct (1) de la revendication 4, dans lequel le corps de connecteur femelle (121) comprend une pluralité de trous de corps (211a) qui pénètrent dans le corps de connecteur femelle (121) dans un sens perpendiculaire au joint de contacts multiples (123) et qui s'ouvrent dans l'espace entre la saillie femelle (1212) et le joint de contacts multiples (123).

6. Ensemble connecteur à couplage direct (1) de n'importe quelle revendication précédente, dans lequel le connecteur mâle (11) comprend en outre un dispositif d'empêchement d'écart (115) configuré pour éviter que le boulon de couplage (110) ne soit déplacé dans un premier sens relativement au corps de connecteur mâle (111), et
le boulon de couplage (110) comprend une portion à pression (181) formée sur une paroi externe du boulon de couplage (110) et configurée pour presser le corps de connecteur mâle (111) et pour éviter que le boulon de couplage (110) ne soit déplacé dans un deuxième sens qui est opposé au premier sens.

7. Ensemble connecteur à couplage direct (1) de la revendication 1, dans lequel un connecteur parmi le connecteur mâle (11) et le connecteur femelle (12) comprend une pluralité de nervures (118) configurées pour être insérées dans l'autre connecteur, et
un intervalle entre deux desdites nervures avoisinantes (118a, 118b) diffère d'un intervalle entre deux autres desdites nervures avoisinantes (118c, 118d).
